# EUROPEAN PATENT APPLICATION

(11) **EP 3 565 007 A1**
(43) Date of publication of application: **06.11.2019**
(21) Application number: 16925756.5
(22) Date of filing: 30.12.2016
(51) Int. Cl.: H01L 29/786, H01L 27/32

(54) **THIN-FILM TRANSISTOR, DISPLAY DEVICE, AND MANUFACTURING METHOD FOR THIN-FILM TRANSISTOR**

(71) Applicant: Shenzhen Royole Technologies Co., Ltd., Shenzhen, Guangdong 518172 (CN)
(72) Inventor: CHEN, Simon, Shenzhen, Guangdong 518172 (CN)
(74) Representative: Mewburn Ellis LLP
(86) International application number: PCT/CN2016/113641
(87) International publication number: WO 2018/120076

(57) **Abstract**

A thin film transistor, a method for manufacturing the thin film transistor, and a display device are provided. The thin film transistor includes a substrate (101), a semiconductor layer (10), a source electrode (20), a drain electrode (30), a gate electrode (50), an insulating layer (40), and a number of floating electrodes (60). The semiconductor layer (10) is formed at the substrate (101). Two first doped regions (11) are respectively formed at two ends of the semiconductor layer (10). The source electrode (20) and the drain electrode (30) are respectively disposed at the first doped regions (11). The gate electrode (50) is disposed between the source electrode (20) and the drain electrode (30). The semiconductor layer (10) between the gate electrode (50) and the drain electrode (30) forms an offset region. A number of spaced second doped regions (12) is formed at the offset region. The insulating layer (40) covers the offset region without the second doped regions (12) formed thereon. A number of floating electrodes (60) is disposed at the insulating layer (40). The arrangement of the second doped regions is beneficial to improve the current driving capability of the thin film transistor.

## Description

### TECHNICAL FIELD

The present disclosure relates to the technical field of displays, and more particularly relates to a thin film transistor, a display device using the thin film transistor, and a method for manufacturing the thin film transistor.

### BACKGROUND

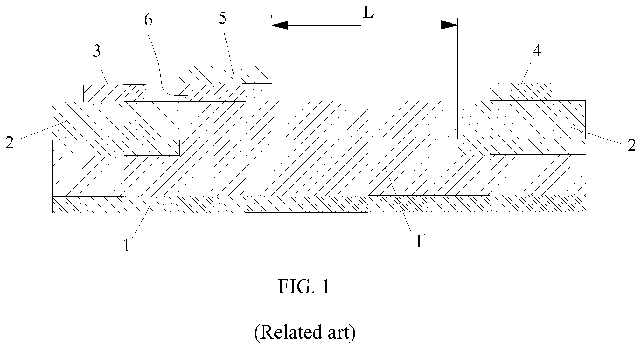

Thin film transistors (TFTs) can be applied to display devices, printers, scanning devices, micro-electromechanical systems (MEMS), planar X-ray sources, etc., and especially applied to the display devices, MEMS, and planar X-ray sources with a broad application prospect. As illustrate in FIG. 1, an offset drain electrode is a basic structure of the TFT. In the TFT, a substrate 1 is provided with a semiconductor layer 1', doped regions 2 are provided at corresponding positions of the semiconductor layer 1', and a source electrode 3 and a drain electrode 4 are respectively disposed at the doped regions 2. An insulating layer 6 is disposed between a gate electrode 5 and the semiconductor layer 1. There is a certain offset between the gate electrode 5 and the drain electrode 4, that is, a distance between the gate electrode 5 and the drain electrode 4 is greater than a distance between the gate electrode 5 and the source electrode 3. As illustrated in FIG. 1, there is an offset distance L between the gate electrode 5 and the drain electrode 4. In this way, the semiconductor layer 1 between the gate electrode 5 and the drain electrode 4 forms an offset region, which causes the high voltage on the drain electrode 4 mainly falling on the offset region, thereby increasing the breakdown voltage of the TFT. The offset region has a significant effect on the breakdown voltage of the TFT with the offset drain electrode. The problem with this structure is that the resistance of the semiconductor layer 1 in the offset region is very high and the on-state current of the TFT with the offset drain electrode is several orders of magnitude smaller than that of a usually used thin film transistor, which affects the current driving capability of the TFT.

### SUMMARY

Embodiments of the present disclosure provide a thin film transistor, a display device using the thin film transistor, and a method for manufacturing the thin film transistor, which are to solve the problem that the current driving capability of the existing thin film transistor is affected after disposing an offset region therein.

To solve the above technical problem, the technical solution of the present disclosure is to provide a thin film transistor. The thin film transistor includes a substrate, a semiconductor layer, an insulating layer, a source electrode, a drain electrode, and a gate electrode. The semiconductor layer is disposed at the substrate. Two ends of the semiconductor layer respectively form two first doped regions. A number of second doped regions is formed between the source electrode and the drain electrode and spaced apart from each other. The gate electrode is disposed between the source electrode and the drain electrode. A distance between the gate electrode and the drain electrode is greater than that between the gate electrode and the source electrode. The semiconductor layer between the gate electrode and the drain electrode correspondingly forms an offset region. The second doped regions are located in the offset region. The thin film transistor further includes a number of floating electrodes. The insulating layer covers the offset region without second doped regions formed thereon. The floating electrodes are correspondingly disposed at the insulating layer. One of the second doped regions is located between the gate electrode and the floating electrode adjacent to the gate electrode. The rest of the second doped regions each are located between the adjacent two of the rest of the floating electrodes.

Preferably, the horizontal cross-sectional widths of the second doped regions are sequentially reduced along a direction from the source electrode to the drain electrode.

Preferably, the number of the second doped regions is three, four, or five.

Preferably, the dose of the dopant in the first doped regions is greater than that in the second doped regions.

Preferably, the dopant in the first doped regions is the same as the dopant in the second doped regions. The dopant is phosphorus ion or boron ion.

Preferably, the first doped regions and the second doped regions are both formed by doping ions ion the semiconductor layer. The dose of ions doped in the first doped regions is 1 × 10¹⁶/cm² and the dose of ions doped in the second doped regions is 5 × 10¹⁵/cm².

A display device includes the above thin film transistor.

A method for manufacturing a thin film transistor, includes providing a substrate and forming a semiconductor layer at the substrate; forming an insulating layer on a side of the semiconductor layer away from the substrate; and correspondingly providing a gate electrode and a number of floating electrodes at the insulating layer, the gate electrode and the floating electrode adjacent the gate electrode spaced apart from each other and the adjacent two floating electrodes spaced apart from each other; doping both ends of the semiconductor layer to form first doped regions, respectively, doping the semiconductor layers without being covered by the floating electrodes and the gate electrode to form a number of second doped regions; disposing a source electrode and a drain electrode at the two first doped regions, respectively.

Preferably, in the process of forming the insulating layer, the gate electrode and the floating electrodes, an insulating material layer and a metal layer are sequentially formed at the semiconductor layer, the insulating material layer and the metal layer are patterned, the insulating material layer forms the insulating layer, and the metal layer forms the gate electrode and the floating electrodes.

Preferably, both the first doped regions and the second doped regions are formed by doping ions in the semiconductor layer. The dose of ions doped in the first doped regions is 1 × 10¹⁶/cm² and the dose of ions doped in the second doped region is 5 × 10¹⁵/cm².

In the present disclosure, the second doped regions are disposed in the offset region of the thin film transistor, and the resistance of the second doped regions is less than that of the semiconductor layer of the existing thin film transistor at the same position. Compared with the existing TFT with the offset drain electrode, the TFT with the additional second doped regions has a greater output current, thereby enhancing the current driving capability of the thin film transistor.

### BRIEF DESCRIPTION OF THE DRAWINGS

FIG. 1 is a schematic structure view of a thin film transistor in related art.
FIG. 2 is a schematic structure view of a thin film transistor according to an embodiment of the present disclosure.
FIG. 3 is a flow chart of a method for manufacturing a thin film transistor according to an embodiment of the present disclosure.
In the companying drawings:

| | | | |
|---|---|---|---|
| 10, | semiconductor layer | 11, | first doped region |
| 12, | second doped region | 20, | source electrode |
| 30, | drain electrode | 40, | insulating layer |
| 50, | gate electrode | 60, | floating electrode |
| 101, | substrate | | |

### DETAILED DESCRIPTION OF ILLUSTRATED EMBODIMENTS

To make the objects, technical solutions, and advantage of the present disclosure more clear, the embodiments of present disclosure will be further described in details below with reference to the accompanying drawings. It can be understood that the specific embodiments described herein are merely illustrative of the present disclosure and are not intended to limit the present disclosure.

It should be noted that when one element is referred to as being "fixed" or "disposed" on another element, which can be directly on another element or indirectly on another element. When one element is referred to as being "connected" to another element, which can be connected directly to another element or indirectly connect to another element.

It should also be noted that the orientation terms, such as left, right, up, down, etc., in this embodiment, are merely relative concepts or reference to the normal use state of the product, and should not be considered as limiting.

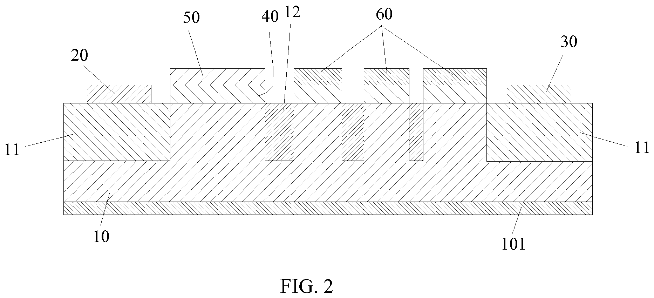

FIG. 2 illustrates a thin film transistor according to an embodiment of the present embodiment. The thin film transistor includes a substrate 101, a semiconductor layer 10 (the material for preparing the semiconductor layer 10 is not limited to the poly-silicon material, that is, the semiconductor layer 10 may also be made of an oxide semiconductor, such as indium gallium zinc oxide (IGZO)), a source electrode 20, a drain electrode 30, a gate electrode 50, an insulating layer 40, and a number of floating electrodes 60. The semiconductor layer 10 is disposed at the substrate 101. Two ends of the semiconductor layer 10 respectively form two first doped regions 11. The source electrode 20 and the drain electrode 30 are respectively disposed at the first doped regions 11 of the two ends of the semiconductor layer 10. The gate electrode 50 is disposed between the source electrode 20 and the electrode drain 30. There are no any doped regions formed at the semiconductor layer 10 corresponding to the gate electrode 50. The semiconductor layer 10 between the gate electrode 50 and the drain electrode 30 forms an offset region. A number of second doped regions 12 are formed in the offset region and spaced apart from each other. The insulating layer 40 covers the semiconductor layer 10 without the first doped regions 11 formed thereon. The gate electrode 50 and the floating electrodes 60 are respectively disposed at the insulating layer 40 and spaced apart from each other. The floating electrodes 60 are disposed between the gate electrode 50 and the drain electrode 30, and spaced apart from each other. The gate electrode 50 and the floating electrodes 60 define a number of second doped regions 12. The second doped regions 12 are located between the adjacent two floating electrodes 60 or located between the gate electrode 50 and the floating electrode 60 adjacent to the gate electrode 50.

In the thin film transistor according to the embodiment of the present disclosure, since the second doped regions 12 are added in the offset region, the resistance of the second doped regions 12 is less than that of the undoped semiconductor layer of the existing thin film transistor. Therefore, the thin film transistor with the added second doped regions 12 has a higher output current. In this way, the thin film transistor has a higher breakdown voltage and enhances the current driving capability at the same time. In addition, the floating electrodes 60 disposed at the offset region to define the second doped regions 12 with the gate electrode 50. The second doped regions 12 optimize the electric field distribution of the offset region. Furthermore, the floating electrodes 60 and the gate electrode 50 may be served as a mask in forming the second doped regions 12, which achieves self-alignment. Therefore, the effect on the electrical characteristics of the thin film transistor due to the alignment deviation when the second doped regions 12 are formed is eliminated.

In the embodiment, the insulating layer 40 is divided into a number of insulating layer units (not illustrated). One of the insulating layer units is disposed between the semiconductor layer 10 and the gate electrode 50 to electrically insulate the semiconductor layer 10 and the gate electrode 50. The rest of the insulating layer units are respectively disposed at the semiconductor layer 10 between the adjacent two second doped regions 12. The gate electrode 50 is disposed at the insulating layer unit adjacent to the source electrode 20. The floating electrodes 60 are disposed at the rest of the insulating layer units. The rest of the insulating layer units accordingly insulate the floating electrodes 60 and the semiconductor layer 10.

It can easily be understood that the intensity of the electric field of the thin film transistor with the offset region gradually becomes weaker in a direction from the source electrode 20 to the drain electrode 30. In the embodiment, the horizontal cross-sectional widths of the floating electrodes 60 are sequentially reduced in the direction from the source electrode 20 to the electrode drain 30 such that the horizontal cross-sectional widths of the second doped regions 12 are sequentially reduced along the same direction. The second doped regions 12 with this structure facilitate smoothing the electric field from the source electrode 20 to the drain electrode 30, further optimizing the electric field distribution of the offset region. In the offset region, the thin film transistor of the embodiment is provided with three second doped regions 12, and the widths of the three second doped regions 12 gradually become smaller in the direction from the source electrode 20 to the drain electrode 30. In other possible embodiments, the number of the second doped regions 12 may be set according to actual requirements. For example, the number of the second doped regions 12 may be set to four, or five, etc. It should be noted that the more the number of the second doped regions 12 is, the more favorable the optimization of the electric field is. However, the number of the second doped regions 12 is more, which may increase the process difficulty. Therefore, the number of the second doped regions 12 needs to be set according to actual needs or process conditions.

In the present disclosure, the dose of the dopant in the first doped regions 11 is greater than that in the second doped regions 12. The first doped regions 11 are a heavily doped region and the second doping regions 12 are a lightly doped region. The dopant is phosphorus ion or boron ion and the resistance of the heavily doped region is lower than that of the lightly doped region. Specifically, the semiconductor layer 10 may be doped with phosphorus ions or boron ions in an ion implantation manner to form the first doped regions 11 and the second doped regions 12, respectively. The dose of the dopant in the first doping regions 11 may be 1×101⁶/cm² and the dose of the dopant in the second doping regions 12 may be 5×10¹⁵/cm². The dose of the dopant may also be adjusted according to actual needs, and is not limited here. Therein, 5×10¹⁵/cm² is the dose of the ion implanted, which means that there are 5×10¹⁵ phosphorus ions or boron ions per square centimeter.

As illustrated in FIG. 2, the breakdown voltage of the offset region of the embodiment is high. To optimize the electric field distribution of the offset region, the connection of the electric field of the offset region is optimized by providing the doped regions 12 in the offset region such that the current driving capability of the offset region is stronger.

According to another aspect of the present disclosure, a display device (not illustrated) is provided. The display device includes the aforementioned thin film transistor. The display device further includes a control module electrically connected to the thin film transistor. The control module changes the output electric drive capability of the thin film transistor by controlling the voltage signal of the thin film transistor. Therein, the display device may be a liquid crystal display device (LCD) or an organic electroluminescence display device (OLED). In the liquid crystal display device, the thin film transistor outputs a display driving force to achieve the driving ability of liquid crystal molecules in different regions of the liquid crystal panel in the display device, thereby realizing a high-resolution developing function. Therein, the control module adopts the existing IC control module or other existing electrical control units capable of meeting the control requirements.

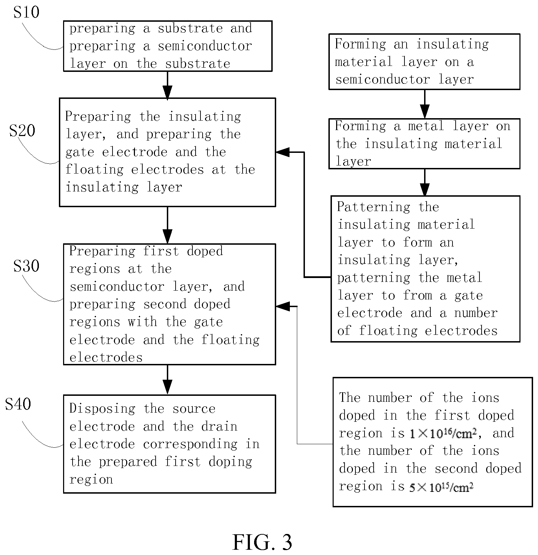

As illustrate in FIG. 3, a method for manufacturing the aforementioned thin film transistor is provided. The method includes operations at following blocks.

At block S10, a substrate 101 is provided and a semiconductor layer 10 is formed at the substrate 101.

At block S20, an insulating layer 40 is formed on a side of the semiconductor layer 10 away from the substrate 101. A gate electrode 50 and a number of floating electrodes 60 are correspondingly disposed at the insulating layer 40. The gate electrode 50 and the floating electrode 60 adjacent to the gate electrode 50 are spaced apart from each other. The adjacent two floating electrodes 60 are spaced apart from each other. In the process of performing step S20, an integral insulating material layer and a metal layer are sequentially formed at the semiconductor layer 10, then the insulating material layer and the metal layer are sequentially patterned such that the insulating material layer forms the insulating layer 40 and the metal layer forms the gate electrode 50 and the floating electrodes 60 (alternatively, the insulating material layer and the metal layer may be simultaneously patterned). The above patterning treatment can be performed by chemical etching. The gate electrode 50 and the floating electrodes 60 are formed simultaneously at the same metal layer (that is, the metal layer is formed at the insulating material layer), and no additional process is required to form the floating electrodes 60, which is conductive to simplifying the forming process.

At block S30, both ends of the semiconductor layer 10 is doped to form two first doped regions 11. The semiconductor layer 10 without being covered by the gate electrode 50 and the floating electrodes 60 is doped to form a number of second doped regions 12. Therein, the order to form the first doped regions 11 and the second doped regions 12 may be interchanged. In other words, the first doped regions 11 may be formed first, and then the second doped regions 12 may be formed, and vice versa.

At block S40, a source electrode 20 and a drain electrode 30 are respectively disposed at the second first doped regions 11.

In the process of manufacturing the thin film transistor, in the process of forming the second doped regions 12, the gate electrode 50 and the floating electrodes 60 cooperatively serve as a mask such that the semiconductor layer 10 without being covered by the gate electrode 50 and the floating electrodes 60 is doped to form the second doped regions 12. Therefore, the process of forming the second doped regions 12 in the offset region is not affected by the alignment deviation. By applying the design structure of the thin film transistor, self-alignment of doping process in the offset region of the thin film transistor can be realized such that the thin film transistor is not affected by the alignment deviation. Compared with the existing thin film transistor, the breakdown voltage of the thin film transistor is higher due to the offset region, which improves the electrical characteristics of the thin film transistor, and enhances the current driving capability of the offset region by providing the second doped regions 12.

The above are only the preferred embodiments of the present disclosure and are not intended to limit the present disclosure. Any modifications, equivalent replacements made within the scopes and principles of the present disclosure, are intended to be included in the scope of the present disclosure.

## Claims

1. A thin film transistor, comprising:
a substrate (101);
a semiconductor layer (10) covering the substrate (101), and the semiconductor layer (10) comprising two first doped regions (11) respectively formed at two ends thereof;
a source electrode (20) formed at one of the first doped regions (11);
a drain electrode (30) formed at the other of the first doped regions (11);
a gate electrode (50) disposed between the source electrode (20) and the drain electrode (30), a distance between the gate electrode (50) and the drain electrode (30) being greater than that between the gate electrode (50) and the source electrode (20), and an offset region formed at the semiconductor layer (10) between the gate electrode (50) and the drain electrode (30);
a plurality of spaced second doped regions (12) disposed between the two first doped regions of the semiconductor layer and located in the offset region;
an insulating layer (40) covering the offset region without the second doped regions (12) formed thereon; and
a plurality of floating electrodes (60) formed at the insulating layer, one of the second doped regions (12) located between the gate electrode (50) and the floating electrode (60) adjacent to the gate electrode (50), and the rest of the second doped regions (12) each located between the adjacent two of the rest of the floating electrodes (60).

2. The thin film transistor of claim 1, wherein the horizontal cross-sectional widths of the second doped regions (12) are sequentially reduced along a direction from the source electrode (20) to the drain electrode (30).

3. The thin film transistor of claim 1, wherein the number of the second doped regions (12) is three, four, or five.

4. The thin film transistor of claim 1 to claim 3, wherein the dose of the dopant in the first doped regions (11) is greater than that in the second doped regions (12).

5. The thin film transistor of claim 4, wherein the dopant in the first doped regions (11) is the same as the dopant in the second doped regions (12) and the dopant is phosphorus ion or boron ion.

6. The thin film transistor of claim 5, wherein the first doped regions (11) and the second doped regions (12) are both formed by doping ions in the semiconductor layer (10), the dose of ions doped in the first doped regions (11) is 1×10¹⁶/cm² and the dose of ions doped in the second doped regions (12) is 5×10¹⁵/cm².

7. A display device, comprising the thin film transistor of any one of claim 1 to claim 6.

8. A method for manufacturing a thin film transistor, comprising:
providing a substrate (101) and forming a semiconductor layer (10) at the substrate (10);
forming an insulating layer (40) on a side of the semiconductor layer (10) away from the substrate (101);
providing a gate electrode (50) and a plurality of floating electrodes (60) at the insulating layer (40), correspondingly, the gate electrode (50) and the floating electrode (60) adjacent to the gate electrode (50) spaced apart from each other, the adjacent two floating electrodes (60) spaced apart from each other;
doping both ends of the semiconductor layer (10) to form two first doped regions (11), respectively, and doping the semiconductor layer (10) without being covered by the gate electrode (50) and the floating electrodes (60) to form a plurality of second doped regions (12); and
disposing a source electrode and a drain electrode at the two first doped regions, respectively.

9. The method of claim 8, wherein in the process of forming the insulating layer (40), the gate electrode (50) and the floating electrodes (60), an insulating material layer and a metal layer are sequentially formed at the semiconductor layer (10), and the insulating material layer and the metal layer are patterned, the insulating material layer forms the insulating layer (40), and the metal layer forms the gate electrode (50) and the floating electrodes (60).

10. The method of claim 8, wherein the first doped regions (11) and the second doped regions (12) are both formed by doping ions in the semiconductor layer (10), the number of ions doped in the first doped regions (11) is 1×10¹⁶/cm², and the number of ions doped in the second doped regions (12) is 5×10¹⁵/cm².
